# EUROPÄISCHE PATENTANMELDUNG

(11) **EP 2 434 648 A1**
(43) Veröffentlichungstag der Anmeldung: **28.03.2012**
(21) Anmeldenummer: 10400047.6
(22) Anmeldetag: 25.09.2010
(51) Int. Cl.: H03M 1/82, H03M 5/08

(54) **Codierer und Decodierer, Codierverfahren und Decodierverfahren sowie System aus Codierer und Decodierer**

(71) Anmelder: ATLAS Elektronik GmbH, 28309 Bremen (DE)
(72) Erfinder: Schmidt, Eberhard, 28207 Bremen (DE)
(74) Vertreter: Wasiljeff, Johannes M.B.

(57) **Zusammenfassung**

Die Erfindung betrifft einen Codierer (36) zur Abbildung eines digitalen Signals (10) in ein Sendesignal (12) und einen Decodierer (44) zur Abbildung eines Empfangssignals (13) in ein digitales Signal (12) zum Übertragen bzw. Empfangen von einem realen Kanal (42). Der Codierer (36) weist Datensymbolen (14) des digitalen Signals (12) Codesymbole (16) eines Coderaumes (40) zu und erzeugt das Sendesignal (12) in Abhängigkeit der Codesymbole (16). Der Decodierer (44) erfasst die Codesymbole (16) in Abhängigkeit des Empfangssignals (13) und weist den Codesymbolen (16) des Coderaumes (40) Datensymbole (14) des digitalen Signals (10) zu. Erfindungsgemäß weisen die Datensymbole (12) jeweils mindestens zwei Bits (18) des digitalen Signals (10) auf. Der Coderaum (40) umfasst dabei Codesymbole (16) zweier Gruppen (38, 39). Jedes Codesymbol (16) weist einen oder eine Mehrzahl von Flankenabständen (28) auf. In der ersten Gruppe (38) entspricht der Flankenabstand (28) bzw. jeder der Flankenabstände (28) dem minimalen Flankenabstand (28a) oder einem ganzzahligen Vielfachen des minimalen Flankenabstands (28a). In der zweiten Gruppe (29) entspricht der Flankenabstand (28) bzw. einer, mehrere oder alle der Mehrzahl von Flankenabständen (28) einem oder mehreren ganzzahligen Vielfachen des minimalen Flankenabstands (28a) zuzüglich einem Bruchteil eines ganzzahligen Vielfachen des minimalen Flankenabstands (28a).

Ferner betrifft die Erfindung ein Verfahren zur Codierung und Codierung sowie ein System (50) aus Codierer (36) und Decodierer (44).

## Beschreibung

Die Erfindung betrifft einen Codierer zur Abbildung eines digitalen Signals in ein Sendesignal nach dem Oberbegriff von Anspruch 1 sowie ein Codierverfahren hierzu nach dem Oberbegriff von Anspruch 11 und einen Decodierer zur Abbildung eines als Sendesignal gesendeten und als Empfangssignal empfangenen Signals in ein digitales Signal nach dem Oberbegriff von Anspruch 5 sowie ein Codierverfahren hierzu nach dem Oberbegriff von Anspruch 12. Ferner betrifft die Erfindung ein System aus einem Codierer zur Abbildung eines digitalen Signals in ein Sendesignal und einem Decodierer zur Abbildung eines als Sendesignal gesendeten und als Empfangssignal empfangenen Signals in ein digitales Signal nach dem Oberbegriff von Anspruch 13.

Im Bereich der Signalübertragung werden digitale Signale häufig mit hohen Datenraten über große Distanzen mit langen Leitungen, z.B. elektrischen Leitungen, übertragen. Ein Beispiel hierfür ist die Übertragung digitaler Signale im bzw. unter Wasser. Hier ist eine Funkübertragung über große Distanzen durch die Dämpfungseigenschaften meist sehr kompliziert oder sogar unmöglich. Gerade bei der Funkübertragung unter Wasser mit hohen Frequenzen, um hohe Datenraten zu übertragen, sind die Dämpfungseigenschaften des Wassers im Vergleich zu niedrigeren Frequenzen stärker ausgeprägt.

Bei der Wasserschallortung werden abgestrahlte Geräusche oder reflektierte Schallwellen mit einer Antenne, z.B. mit einer Schleppantenne, empfangen. Dazu weist die Antenne eine Vielzahl von Wandlern, z.B. elektroakustischen Wandlern, auf, die die Schallwellen in elektrische Signale umwandeln, sowie den jeweiligen Wandlern jeweils zugeordnete Signalverarbeitungseinheiten, welche die elektrischen Wandlersignale vorverarbeiten und in digitale Signale wandeln. Eine zentrale Signalverarbeitungseinrichtung, die im Bootskörper angeordnet ist, wertet die digitalen Signale der dem Wandler zugeordneten Signalverarbeitungseinheit aus und verarbeitet diese weiter. Bestimmte Antennen zur Wasserschallortung, wie Schleppantennen, sind räumlich weit ausgedehnt, um z.B. tiefe Frequenzen, der im Wasser vorherrschenden Wellenlängen, aufnehmen zu können. Bedingt durch diese Ausdehnung, sind lange Leitungen zwischen den Wandlern und der zentralen Signalverarbeitungseinrichtung unerlässlich.

Das digitale Signal wird zur Übertragung auf der Leitung, die auch als realer Kanal bezeichnet werden kann, in einem in der jeweiligen Signalverarbeitungseinheit vorgesehenen Codierer auf ein Sendesignal abgebildet. Das empfangene Sendesignal, also das Empfangssignal, wird nach der Übertragung in einem in der zentralen Signalverarbeitungseinrichtung vorgesehenen Decodierer wieder auf das digitale Signal abgebildet. Gemäß dem Stand der Technik wird die Codierung bzw. die Decodierung nach dem Non-Return-To-Zero-Verfahren durchgeführt.

Bei der üblichen Auslegung des Non-Return-To-Zero-Verfahrens zur Codierung bzw. Decodierung werden Datensymbole aus dem digitalen Signal gebildet. Jedes Bit des digitalen Signals entspricht hierbei genau einem Datensymbol, wobei sich dadurch genau zwei unterschiedliche Datensymbole mit dem Binärwert "0" und "1" ergeben. Ferner werden Codesymbole mit jeweils unterschiedlichen Potentialniveaus definiert. Um jedem unterschiedlichen Datensymbol ein definiertes Codesymbol zuweisen zu können, werden im Falle des Non-Return-To-Zero-Verfahrens, entsprechend der unterschiedlichen Datensymbole, zwei unterschiedliche Codesymbole definiert. Diese beiden unterschiedlichen Codesymbole bilden einen sogenannten Coderaum. Das erste Codesymbol des Coderaums wird z.B. als ein niedriges Potentialniveau und das zweite Codesymbol z.B. als ein hohes Potentialniveau definiert.

Zur Übertragung werden den aus dem digitalen Signal gebildeten Datensymbolen im Codierer jeweils das dem Datensymbol entsprechende Codesymbol zugewiesen. In Abhängigkeit der Codesymbole wird dann das Sendesignal erzeugt.

Analog dem Codierer werden in einem Decodierer Codesymbole in Abhängigkeit von einem Empfangssignal erfasst und jeweils den entsprechenden Datensymbolen zugewiesen. Aus den Datensymbolen wird zuletzt wieder das digitale Signal gebildet.

Im einfachsten Fall wird das Sendesignal im Codierer in Abhängigkeit der Codesymbole erzeugt, indem das Potentialniveau der Codesymbole auf der Leitung erzeugt wird. Ein hohes Potentialniveau kann z.B. als 5V und ein niedriges Potentialniveau z.B. als 0V auf der Leitung erzeugt werden. Die Codesymbole werden in Abhängigkeit vom Empfangssignal im Decodierer erfasst, indem das Potentialniveau der Leitung gemessen wird und daraus das Codesymbol erfasst wird.

Dem Non-Return-To-Zero-Verfahren wird eine Taktfrequenz zugrunde gelegt. Mit jedem Takt der Taktfrequenz wird das Sendesignal, in Abhängigkeit des Potentialniveaus eines Codesymbols, erzeugt und somit ein Bit des digitalen Signals in das Sendesignal abgebildet. Ferner treten Signalflanken zwischen Codesymbolen mit unterschiedlichen Potentialniveaus auf. Zwischen aufeinanderfolgenden Signalflanken kann der zeitliche Abstand bestimmt werden, der als Flankenabstand bezeichnet wird.

Durch die der Taktfrequenz entsprechenden Periodendauer wird ein minimaler Flankenabstand definiert. Dieser minimale Flankenabstand entspricht dem zeitlichen Abstand zwischen zwei Signalflanken, die auftreten, wenn Codesymbole aufeinanderfolgen, die jeweils unterschiedliche Potentialniveaus aufweisen. Beispielhaft könnte hier die Bitfolge "010" eines digitalen Signals betrachtet werden. Hieraus ergeben sich ein Datensymbole mit dem Binärwert "0", eine Datensymbol mit dem Binärwert "1" und ein weiteres Datensymbol mit dem Binärwert "0". Den Datensymbolen werden entsprechend die Codesymbole zugewiesen, wodurch sich ein Codesymbol mit einem niedrigen Potentialniveau gefolgt von einem Codesymbol mit einem hohen Potentialniveau wiederum gefolgt von einem Codesymbol mit einem niedrigen Potentialniveau ergeben. Bei diesem Beispiel entstehen zwei Signalflanken der drei Codesymbole, deren Abstand als minimaler Flankenabstand bezeichnet wird. Ein geringerer Flankenabstand kann nicht auftreten, da sich das Potentialniveau der Codesymbole maximal einmal pro Takt ändert.

Beim Übertragen von digitalen Signalen mit dem Non-Return-To-Zero-Verfahren treten also benachbarte Signalflanken mit dem o.g., durch die Taktfrequenz bestimmten minimalen Flankenabstand und mit Flankenabständen auf, die dem ganzzahligen Vielfachen des minimalen Flankenabstands entsprechen.

Beim Non-Return-To-Zero-Verfahren ist also die Bitrate, nämlich die übertragbare Anzahl der Bits pro Sekunde, abhängig von der Taktfrequenz bzw. der Periodendauer. Die Bitrate ist dadurch begrenzt, dass die Leitung, wie etwa eine elektrische Leitung, für die Übertragung reale physikalische Eigenschaften aufweist und somit als realer Kanal betrachtet werden kann. Aufgrund z.B. der Leitungskapazität einer elektrischen Leitung steigen die Signalflanken zwischen den Potentialwechseln flach an bzw. fallen flach ab.

Soll nun die Bitrate erhöht werden, tritt - bedingt durch die Verkürzung der Periodendauer des Taktes - ein minimaler Flankenabstand auf, der so kurz ist, dass die aus den Codesymbolen erzeugten Signalflanken des Sendesignal durch den flachen Anstieg bzw. den flachen Abfall der Leitungskapazität auf der elektrischen Leitung ein angestrebtes Potentialniveau nicht erreichen, bevor die nächste Signalflanke in entgegengesetzter Richtung folgt. In einem Decodierer ergibt sich beim Empfangen dieses als Empfangssignal empfangen Sendesignals das Problem, dass keine unterschiedlichen Potentialniveaus erfasst werden, obwohl diese erzeugt wurden.

Es sind noch weitere Verfahren bekannt, die jedoch alle auf dem Prinzip beruhen, dass pro Takt maximal ein Bit übertragen wird. Wird dazu eine Taktrate mit einem minimalen Flankenabstand herangezogen, der bzgl. der Leitungskapazität noch fehlerfrei übertragen werden kann, so ist die zugrundegelegte Frequenz bei bekannten Verfahren gerade das Maß zur Bestimmung der maximalen Bitrate.

Soll also auf einer elektrischen Leitung die Bitrate über die maximale z.B. durch das Non-Return-To-Zero-Verfahren ermöglichte Bitrate erhöht werden, führt dies zu einer fehlerbehafteten Übertragung des digitalen Signals.

Der Erfindung liegt daher die Aufgabe zugrunde, die maximale Bitrate der Übertragung auf einem realen Kanal im Vergleich zu bekannten Verfahren zu erhöhen.

Die Erfindung löst dieses Problem durch die Merkmale eines Codierers zur Abbildung eines digitalen Signals in ein Sendesignal gemäß Anspruch 1 sowie ein Codierverfahren hierzu gemäß Anspruch 11, einen Decodierer zur Abbildung eines als Sendesignal gesendeten und als Empfangssignal empfangenen Signals in ein digitales Signal gemäß Anspruch 5 sowie ein Decodierverfahren hierzu gemäß Anspruch 12 und ein System aus einem Codierer zur Abbildung eines digitalen Signals in ein Sendesignal und eines Decodierers zur Abbildung eines als Sendesignal gesendeten und als Empfangssignal empfangenen Signals gemäß Anspruch 13.

Der erfindungsgemäße Codierer sowie Decodierer, das erfindungsgemäße Codierverfahren und Decodierverfahren sowie das erfindungsgemäße System aus Codierer und Decodierer sind vorteilhaft derart ausgelegt, dass eine Erhöhung der Bitrate gegenüber der mit dem Non-Return-To-Zero-Verfahren erzielbaren maximalen Bitrate ermöglicht wird.

Die Erfindung sieht zu diesem Zweck einen Codierer zur Abbildung, d.h. zum Codieren, eines digitalen Signals in ein Sendesignal vor, das auf einem realen Kanal übertragen wird. Dazu ist der Codierer derart ausgebildet, um Datensymbolen Codesymbole eines Coderaums zuzuweisen. Ferner ist der Codierer derart ausgebildet, um das Sendesignal in Abhängigkeit der Codesymbole zu erzeugen. Hierbei weist das Sendesignal Signalflanken auf, die aus dem Übergang eines Potentialniveaus zu einem anderen Potentialniveau bestehen. Ferner weist das Sendesignal Flankenabstände, die durch den zeitlichen Abstand zwischen zwei gleichen oder unterschiedlichen Potentialen benachbarter Signalflanken definiert sind, auf. D.h. ein Flankenabstand des Sendesignals ist dadurch festgelegt, dass z.B. ein Potential der ersten der benachbarten Signalflanken des Sendesignals vorbestimmt wird und ein zweites Potential der zweiten der benachbarten Signalflanken vorbestimmt wird und der zeitliche Abstand zwischen den vorbestimmten Potentialen den Flankenabstand des Sendesignals ergibt.

Die Datensymbole weisen jeweils zwei oder mehr als zwei Bits des digitalen Signals auf. Der Coderaum umfasst Codesymbole zweier unterschiedlicher Gruppen, die sich bezüglich ihrer Flankenabstände unterscheiden, wobei jedes Codesymbol einen oder eine Mehrzahl von Flankenabständen aufweist. In der ersten Gruppe entspricht der Flankenabstand bzw. jeder der Flankenabstände dem minimalen Flankenabstand oder einem ganzzahligen Vielfachen des minimalen Flankenabstands. In der zweiten Gruppe entspricht bzw. entsprechen der Flankenabstand bzw. einer, mehrere oder alle der Mehrzahl von Flankenabständen einem oder mehreren ganzzahligen Vielfachen des minimalen Flankenabstands zuzüglich einem Bruchteil eines ganzzahligen Vielfachen des minimalen Flankenabstands.

Vorteil des Codierers ist, dass eine Übertragung mit höherer Bitrate im Vergleich zu bekannten Codierern möglich ist, indem bereits durch einen minimalen Flankenabstand Datensymbole mit zwei oder mehr als Bits übertragen werden. Weiterer Vorteil ist, dass Codesymbole mit einem oder einer Mehrzahl von Flankenabständen definiert werden, die nicht auf ein ganzzahliges Vielfaches des minimalen Flankenabstands, also die ersten Gruppe von Codesymbolen, begrenzt sind. Erfindungsgemäß werden auch Codesymbole mit einem oder einer Mehrzahl von Flankenabständen erzeugt, die dem ein- oder mehrfachen ganzzahligen Vielfachen eines minimalen Flankenabstands zuzüglich einem Bruchteil des minimalen Flankenabstands entsprechen und somit der zweiten Gruppe von Codesymbolen zuzuordnen sind. Flankenabstände der erfindungsgemäßen Codesymbole sind also nicht auf ein festes Raster, wie z.B. einen Takt, wie bei bekannten Verfahren, beschränkt.

Nach einer weiteren vorteilhaften Ausbildung ist der Codierer derart ausgebildet, um gleichen Datensymbolen jeweils das gleiche Codesymbol zuzuweisen. Gleiche Datensymbole sind Datensymbole, die jeweils die gleiche Anzahl Bits aufweisen, wobei die Bits gleicher Datensymbole die gleichen Binärwerte in gleicher Reihenfolge aufweisen. Gleiche Codesymbole weisen die gleiche Anzahl von Flankenabständen auf, wobei die Flankenabstände bei gleichen Codesymbolen mit mehreren Flankenabständen zusätzlich jeweils die gleichen Reihenfolgen von Flankenabständen aufweisen.

Durch die Zuweisung jeweils des gleichen Datensymbols zum gleichen Codesymbol muss der Coderaum maximal nur eine Anzahl unterschiedlicher Codesymbole enthalten, die der Anzahl der unterschiedlichen Datensymbole entspricht. Somit ist die Abbildung des digitalen Signals auf das Sendesignal bijektiv und kann mit einer Tabelle, die nur die möglichen Datensymbole und die jeweils entsprechenden Codesymbole enthält, technisch einfach realisiert werden.

Ferner ist es vorteilhaft, dass der Codierer derart ausgebildet ist, um jedes Datensymbol aus der gleichen Anzahl von Bits zusammenzufassen. Es wird also eine Anzahl festgelegt und jedes Datensymbol wird aus genau dieser Anzahl von Bits des digitalen Signals gebildet.

Vorteilhaft ist, dass die Anzahl der unterschiedlichen Datensymbole durch die Anzahl der festgelegten Bits begrenzt ist. Wird etwa die Anzahl der Bits auf zwei Bits festgelegt, so sind vier unterschiedliche Datensymbole möglich. Wird die Anzahl der Bits z.B. auf vier festgelegt, sind sechzehn verschiedene Datensymbole möglich. Zudem werden die den Datensymbolen zugewiesenen Codesymbole bzgl. ihrer Anzahl beschränkt und der Codierer muss dadurch ebenso weniger unterschiedliche Codesymbole erzeugen und ist technisch einfacher realisierbar.

Gemäß einer weiteren bevorzugten Ausbildung besteht jedes der Codesymbole aus der gleichen Anzahl eines oder mehrerer Flankenabstände. Es wird dazu eine Anzahl festgelegt und jedes der Codesymbole enthält genau die dieser Anzahl entsprechende Anzahl von Flankenabständen.

Vorteilhafterweise muss das Codesymbol ausschließlich die Information des Datensymbols und nicht zusätzlich die Anzahl der Flankenabstände des entsprechenden Codesymbols enthalten, um im Decodierer erfasst zu werden. Bei Codesymbolen mit unterschiedlicher Anzahl von Flankenabständen, müsste diese Anzahl der Flankenabstände nämlich ebenfalls in den Codesymbolen codiert werden, um dem Decodierer eine Information zu geben, wie viele Flankenabstände das jeweilige Codesymbol umfasst.

Ferner betrifft die Erfindung einen Decodierer zur Abbildung, d.h. zum Decodieren, eines als Sendesignal gesendeten und als Empfangssignal empfangenen Signals in ein digitales Signal, das von einem realen Kanal empfangen wird. Dazu ist der Decodierer derart ausgebildet, um Codesymbolen eines Coderaums Datensymbole zuzuweisen. Ferner ist der Decodierer derart ausgebildet, um die Codesymbole in Abhängigkeit des Empfangssignals zu erfassen. Das Empfangssignal weist dazu Signalflanken auf, die aus dem Übergang eines Potentialniveaus zu einem anderen Potentialniveau bestehen. Zwischen mindestens zwei gleichen oder unterschiedlichen vorbestimmten Potentialen benachbarter Signalflanken sind Flankenabstände definiert. Die Datensymbole weisen zwei oder mehr als zwei Bits des digitalen Signals auf. Der Coderaum umfasst Codesymbol zweier unterschiedlicher Gruppen, die sich bezüglich ihrer Flankenabstände unterscheiden, wobei jedes Codesymbol einen oder eine Mehrzahl von Flankenabständen aufweist. In der ersten Gruppe entspricht der Flankenabstand bzw. jeder der Flankenabstände dem minimalen Flankenabstand oder einem ganzzahligen Vielfachen des minimalen Flankenabstands. In der zweiten Gruppe entspricht bzw. entsprechen der Flankenabstand bzw. einer, mehrere oder alle der Mehrzahl von Flankenabständen einem oder mehreren ganzzahligen Vielfachen des minimalen Flankenabstands zuzüglich einem Bruchteil eines ganzzahligen Vielfachen des minimalen Flankenabstands.

Der Decodierer hat den Vorteil, dass dieser Empfangssignale mit einer höheren Bitrate als herkömmliche Decodierer empfangen kann, da mit diesem Decodierer pro Flankenabstand mehr als ein Bit erfasst wird und auch Flankenabstände erfasst werden können, die neben dem ein- oder mehrfachen ganzzahligen Vielfachen des minimalen Flankenabstands auch dem ein- oder mehrfachen ganzzahligen Vielfachen des minimalen Flankenabstands zuzüglich einen Bruchteil des minimalen Flankenabstands entsprechen. Insbesondere können mit dem Decodierer die Codesymbole des erfindungsgemäßen Codierers decodiert werden.

Gemäß einer weiteren bevorzugten Ausbildung ist der Decodierer derart ausgebildet, um gleichen Codesymbolen jeweils das gleiche Datensymbol zuzuweisen. Gleiche Codesymbole weisen die gleiche Anzahl von Flankenabständen auf, wobei die Flankenabstände bei gleichen Codesymbolen mit mehreren Flankenabständen zusätzlich jeweils die gleiche Reihenfolge von Flankenabständen aufweisen. Gleiche Datensymbole sind Datensymbole, die jeweils die gleiche Anzahl Bits aufweisen, wobei die Bits gleicher Datensymbole die gleichen Binärwerte in gleicher Reihenfolge aufweisen.

Vorteilhafterweise muss im Decodierer nur die Anzahl von Codesymbolen erkannt werden, die der Anzahl der unterschiedlichen möglichen Datensymbole entspricht. Somit ist die Abbildung des Empfangssignals auf das digitale Signal bijektiv und kann mit einer gespiegelten Tabelle der Tabelle, die im Codierer abgelegt ist, technisch einfach realisiert werden.

Ferner ist es vorteilhaft, dass der Decodierer derart ausgebildet ist, um jedes Datensymbol in die gleiche Anzahl von Bits aufzuteilen.

Dadurch, dass jedes Datensymbol die gleiche Anzahl von Bits umfasst, die vorbestimmt wird, wird die Anzahl der unterschiedlichen Datensymbole durch die Anzahl der festgelegten Bits begrenzt. Demgemäß werden auch die Codesymbole begrenzt und der Decodierer muss dadurch weniger unterschiedliche Codesymbole erfassen und ist technisch einfacher realisierbar.

Gemäß einer weiteren bevorzugten Ausbildung des Codierers besteht jedes der Codesymbole aus der gleichen Anzahl eines oder mehrerer Flankenabstände.

Im Decodierer muss somit keine Information aus bereits empfangenen Flankenabständen eines Codesymbols erfasst werden, die weitere Auskunft über noch folgende Flankenabstände, die ebenfalls zum aktuell empfangenen Codesymbol gehören könnten, geben.

Jedes Codesymbol weist erfindungsgemäß einen festgelegten Flankenabstand oder mehrere festgelegte Flankenabstände einer festgelegten Reihenfolge auf. Dazu ist der Decodierer derart ausgelegt, um jedes Codesymbol durch einen festgelegten Flankenabstand oder mehrere festgelegte Flankenabstände einer festgelegten Reihenfolge eindeutig zu erfassen. Gemäß einer vorteilhaften Weiterbildung ist der Codierer auch ausgebildet, um Codesymbole mit einem oder mehreren Flankenabständen, die um einen Toleranzwert abweichen, als Codesymbole mit einem oder mehreren Flankenabständen zu erfassen, die nicht um einen Toleranzwert abweichen.

Es werden somit im Decodierer auch Codesymbole erkannt, deren Flankenabstand bzw. Flankenabstände um einen Toleranzwert von einem oder mehreren im Codesymbol definierten Flankenabständen abweicht. Dies ist dann sinnvoll, wenn geringe Störungen auf den realen Kanal dazu führen, dass Signalflanken verzögert oder verfrüht übertragen werden. Trotz o.g. geringer Störungen werden dadurch weiterhin Codesymbole eindeutig erkannt.

Vorteilhafterweise ist der Decodierer derart ausgebildet, um die Flankenabstände, die nicht zur Erfassung eines Codesymbols führen, als Übertragungsfehler zu erkennen. Ein oder mehrere Flankenabstände, die um mehr als den Toleranzwert von den Flankenabständen der definierten Codesymbole abweichen, werden also nicht als definierte Codesymbole erkannt und als Übertragungsfehler gekennzeichnet.

Vorteilhafterweise werden Übertragungsfehler erkannt, um Codesymbole nicht falsch zuzuordnen und dadurch falsche digitale Signale zu empfangen. Auf einen Übertragungsfehler kann dann entsprechend mit einer weiteren Signalverarbeitung reagiert werden, indem z.B. das Codesymbol ignoriert wird.

Ein vorteilhaftes Decodierverfahren zum Abbilden eines digitalen Signals in ein Sendesignal zum Übertragen auf einen realen Kanal mit einem erfindungsgemä-βen Codierer ist in Anspruch 11 angegeben.

Ein vorteilhaftes Decodierverfahren zum Abbilden eines als Sendesignal gesendeten und als Empfangssignal empfangenen Signals in ein digital Signal zum Empfangen von einem realen Kanal mit einem erfindungsgemäßen Decodierer ist in Anspruch 12 angegeben.

Ein vorteilhaftes System aus einem erfindungsgemäßen Codierer zur Durchführung eines erfindungsgemäßen Codierverfahrens und einem erfindungsgemäßen Decodierer zum Durchführung eines erfindungsgemäßen Decodierverfahrens ist in Anspruch 13 angegeben.

Weitere vorteilhafte Ausführungsformen ergeben sich aus den Unteransprüchen sowie aus den anhand der beigefügten Zeichnung näher erläuterten Ausführungsbeispielen. In der Zeichnung zeigen:
- Fig. 1: ein digitales Signal, das mit dem bekannten Non-Return-To-ZeroVerfahren in einem Codierer in ein Sendesignal abgebildet wird;
- Fig. 2: die gleiche Abbildung des digitalen Signals in ein Sendesignal jedoch mit höherer Bitrate als in Fig. 1, wodurch die Übertragung fehlerhaft wird;
- Fig. 3: gemäß einer vorteilhaften erfindungsgemäßen Ausbildungsform gebildete Daten und Codesymbole, sowie deren Zuordnung zueinander;
- Fig. 4: die Abbildung des digitalen Signals aus Fig. 1 und 2 auf ein Sendesignal mit dem erfindungsgemäßen Verfahren, wobei eine Bitrate erreicht wird, die höher als in Fig. 1 ist und gleichzeitig eine fehlerfreie Übertragung gewährleistet;
- Fig. 5: einen erfindungsgemäßen Codierer zur Abbildung eines digitalen Signals in ein Sendesignal zur Übertragung auf einen realen Kanal;
- Fig. 6: einen erfindungsgemäßen Decodierer zur Abbildung eines als Sendesignal gesendeten und als Empfangssignal empfangenen Signals in ein digitales Signal zum Empfangen von einem realen Kanal:
- Fig. 7: ein System aus dem erfindungsgemäßen Codierer und dem erfindungsgemäßen Decodierer;
- Fig. 8: zwei Ausschnitte eines Sendesignals, die jeweils das Sendesignal in Abhängigkeit von unterschiedlichen Codesymbolen zeigen und
- Fig. 9: gemäß einer weiteren vorteilhaften erfindungsgemäßen Ausbildungsform gebildete Daten und Codesymbole, sowie deren Zuordnung zueinander.

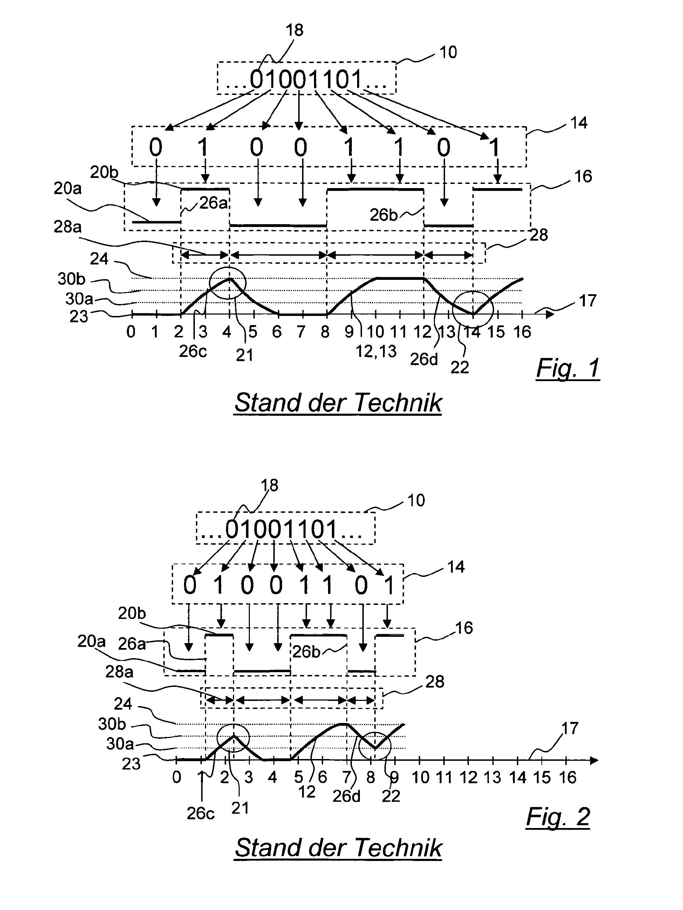

Die Fig. 1 und 2 zeigen einen Ausschnitt aus einem digitalen Signal 10, das auf das Sendesignal 12 abgebildet wird, für den Fall der Codierung mit dem bekannten Non-Return-To-Zero-Verfahren. Die Fig. 1 und 2 unterscheiden sich dadurch, dass jeweils unterschiedliche Bitraten für die Übertragung zugrunde gelegt werden.

Fig. 1 zeigt einen Ausschnitt aus einem digitalen Signal 10, bestehend aus einer Bitfolge "01001101", aus dem Datensymbole 14 gebildet werden, die jeweils den Codesymbolen 16 zugewiesen werden. Aus den Codesymbolen 16 wird ein Sendesignal 12 in Abhängigkeit der Codesymbole 16 erzeugt.

Nach dem bekannten Verfahren wird jedes Datensymbol 14 aus einem Bit 18 des digitalen Signals 10 gebildet. Entsprechend der möglichen Binärwerte eines Bits 18 können genau zwei unterschiedliche Datensymbole 14 aus dem digitalen Signal 10 gebildet werden. Beim bekannten Verfahren weist der Coderaum für jedes Datensymbol 14 ein Codesymbol 16, also zwei unterschiedliche Codesymbole auf. Eines der Codesymbole 16 weist ein niedriges Potentialnivea 20a und das andere Codesymbol 16 weist ein hohes Potentialniveau 20b auf.

Diese unterschiedlichen Codesymbole 16 werden im Codierer entsprechend den unterschiedlichen Datensymbolen 14 zugewiesen. Dem Datensymbol 14 mit dem Binärwert "0" wird ein Codesymbol 16 mit dem niedrigen Potential 20a und dem Datensymbol 14 mit dem Binärwert "1" wird entsprechend ein Codesymbol 16 mit einem hohen Potential 20b zugewiesen.

Im Übergang zwischen dem niedrigen Potentialniveau 20a und dem hohen Potentialniveau 20b der Codesymbole 16 entstehen Signalflanken 26a, 26b. Diese verlaufen jedoch sehr steil und können als Sprünge ohne Zeitverzug betrachtet werden. Zwischen den Signalflanken der Codesymbole werden Flankenabstände 28 als zeitlicher Abstand zwischen aufeinanderfolgenden Signalflanken 26a, 26b der Codesymbole definiert.

In Abhängigkeit der Codesymbole 16 wird das Sendesignal 12 erzeugt, indem z.B. die Potentialniveaus 20a, 20b direkt auf einem realen Kanal erzeugt werden. Dadurch erreicht das Sendesignal 12 in Bereichen 22 ein minimales Potentialniveau 23 und in anderen Bereichen 21 ein maximales Potentialniveau 24.

Auch beim Sendesignal 12 entstehen im Übergang zwischen dem minimalen Potentialniveau 23 und dem maximalen Potentialniveau 24 sowie im Übergang zwischen dem maximalen Potential 24 und dem minimalen Potential 23 Signalflanken 26c, 26d. Die Signalflanken 26c, 26d des Sendesignals weisen jedoch im Vergleich zu den Signalflanken 26a, 26b der Codesymbole aufgrund der kapazitiven Eigenschaften des realen Kanals, z.B. einer elektrischen Leitung, einen flachen Anstieg bzw. einen flachen Abfall auf.

Ferner wird dem Non-Return-To-Zero-Verfahren einen Taktfrequenz zugrunde gelegt. Mit jedem Takt der Taktfrequenz wird das Sendesignal 12 in Abhängigkeit eines Codesymbols 16 mit einem niedrigen Potentialniveau 20a oder einem hohen Potentialniveau 20b erzeugt. Diese Taktfrequenz entspricht somit der Bitrate. Durch die der Taktfrequenz entsprechende Periodendauer wird ein minimaler Flankenabstand 28a definiert. Dieser minimale Flankenabstand 28a entspricht dem zeitlichen Abstand zwischen zwei Signalflanken 26a, 26b der Codesymbole 16, die auftreten, wenn aufeinanderfolgende Codesymbole 16 jeweils unterschiedliche Potentialniveaus aufweisen. Alle weiteren, neben dem minimalen Flankenabstand 28a möglichen Flankenabstände 28 der Codesymbole, weisen ein ganzzahliges Vielfaches des minimalen Flankenabstands 28a auf.

Wie oben aufgeführt, weist das Sendesignal 12 flache Signalflanken 26c, 26d auf, die im Falle der zugrunde gelegten Bitraten in Fig.1 das maximale Potentialniveau 24 bzw. das minimale Potentialniveau 23 erreichen, bevor - bedingt durch den minimalen Flankenabstand 28a der Codesymbole - eine neue Signalflanke 26c, 26d auftritt.

Ferner sind Entscheiderschwellen 30a, 30b dargestellt, die im Decodierer beim Non-Return-To-Zero-Verfahren zur Erfassung der Codesymbole 16 definiert werden. Im realen Fall wird ein Empfangssignal 13 sich gegenüber dem Sendesignal 12, bzgl. z.B. der Amplitude, unterscheiden. In Fig. 1 wird jedoch zur einfacheren Darstellung davon ausgegangen, dass das Sendesignal 12 dem Empfangssignal 13 entspricht.

Im Decodierer werden in Abhängigkeit von diesem Empfangssignal 13 die Codesymbole 16 erfasst. Ein Codesymbol 16 mit einem niedrigen Potentialniveau 20a wird erfasst, wenn die untere Entscheiderschwelle 30a in einem bestimmten Zeitbereich unterschritten wird und ein Codesymbol 16 mit dem hohen Potentialniveau 20b wird erfasst, wenn die obere Entscheiderschwelle 30b in einem bestimmten Zeitbereich überschritten wird.

Im in Fig. 1 dargestellten Fall kann also ein digitales Signal 10 mit dem Non-Return-To-Zero-Verfahren fehlerfrei auf einem realen Kanal übertragen und erfasst werden. Hierfür werden bei zugrundegelegter Bitrate sechzehn Zeiteinheiten, die auf der Zeitachse 17 abzulesen sind, benötigt.

Fig. 2 zeigt ebenso die Abbildung eines digitalen Signals 10 auf ein Sendesignal 12 mit dem Non-Return-To-Zero-Verfahren, die der Abbildung in Fig. 1 entspricht. Gleiche Bezugszeichen bezeichnen hier gleiche Merkmale. Im Unterschied zu Fig. 1 ist jedoch die Bitrate bzw. die dem Verfahren zugrunde gelegte Taktfrequenz erhöht worden. Vergleicht man die Zeitachse 17 der Fig. 1 mit der Zeitachse 17 der Fig. 2, so ist zu erkennen, dass die Bitrate annähernd verdoppelt wurde. Ebenfalls wird der gleiche reale Kanal zugrunde gelegt, der gleiche kapazitive Effekte, wie in Fig. 1, aufweist. Aufgrund des vergleichbaren Kanals weisen die Signalflanken 26c, 26d des Sendesignals 12 in Fig. 2 ebenfalls die gleiche flache Steigung, wie in Fig. 1, auf.

Im Gegensatz zu Fig. 1 wird durch die Erhöhung der Bitrate der minimale Flankenabstand 28a zwischen den Signalflanken 26a, 26b der Codesymbole 16 zeitlich verkürzt. Daher erreicht das Sendesignal 12 ein minimale Potentialniveau 23 in Bereichen 22 und ein maximales Potentialniveau 24 in Bereichen 21 nicht. Diese Bereiche 21, 22 treten auf, wenn aufeinanderfolgende Codesymbole 16 unterschiedliche Potentialniveaus 20a, 20b aufweisen und das Sendesignal 12 in Abhängigkeit dieser unterschiedlichen Codesymbole 16 erzeugt wird, weil dadurch Signalflanken 26c, 26d des Sendesignals zu schnell nacheinander erzeugt werden.

In einem Decodierer wird bei dieser Bitrate das Empfangssignal 13 durch die flache Steigung der Signalflanken 26c, 26d des Sendesignals 12 bzw. des Empfangssignals 13 in o.g. Bereichen 21, 22, in denen die untere Entscheiderschwelle 30a nicht mehr unterschritten bzw. die oberen Entscheiderschwelle 30b nicht mehr überschritten wird, falsch empfangen. Im Decodierer würden also in den o.g. Bereichen 21, 22 abhängig vom Empfangssignal 13 falsche Codesymbole 16 erfasst werden.

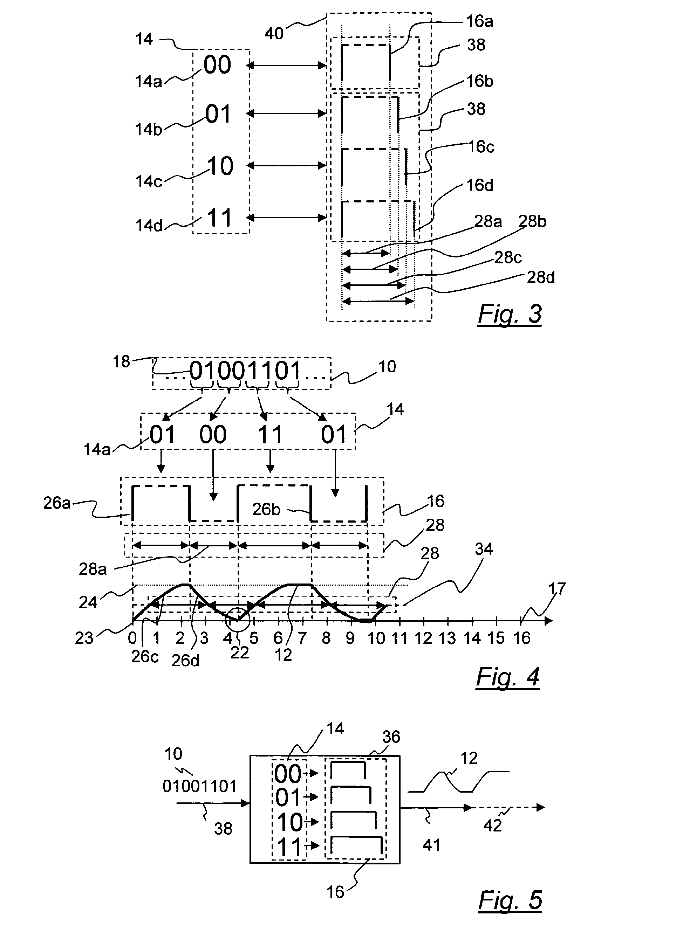

Fig. 3 zeigt eine erste vorteilhafte Ausbildung der im erfindungsgemäßen Codierer bzw. Decodierer einander zugeordneten Daten und Codesymbole.

Es werden Datensymbole 14a - 14d aus mindestens zwei Bits 18 gebildet. Dadurch ergeben sich genau vier unterschiedliche Datensymbole 14a - 14d. Zusätzlich werden vier unterschiedliche Codesymbole 16 zweier Gruppen 38, 39 gebildet. Die Codesymbole 16 beider Gruppen 38, 39 bilden den Coderaum 40. Der Flankenabstand 28 des oberen dargestellten Codesymbols 16a ist dabei der ersten Gruppe 38 von Codesymbolen 16 zu zuordnen. Diese erste Gruppe 38 von Codesymbolen 16 weist Codesymbole 16 mit jeweils einem oder einer Mehrzahl von Flankenabständen 28 mit jeweils einem oder mehreren ganzzahligen Vielfachen des minimalen Flankenabstands 28a auf. Auch die Codesymbole 16 des Non-Return-To-Zero-Verfahrens gehören zu dieser ersten Gruppe 38 von Codesymbolen 16. Erfindungsgemäß sind die weiteren Codesymbole 16b - 16d jedoch einer zweiten Gruppe 39 von Codesymbolen 16 zuzuordnen. Diese zweite Gruppe 39 umfasst Codesymbole 16 mit einem oder einer Mehrzahl von Flankenabständen 28, wobei einer mehrere oder alle der Mehrzahl von Flankenabständen 28 einem oder mehreren ganzzahligen Vielfachen des minimalen Flankenabstands 28a zuzüglich einem Bruchteil des minimalen Flankenabstands 28a entsprechen.

Das obere Codesymbol 16a weist den minimalen Flankenabstand 28a auf. Das darunterliegende Codesymbol 16b weist einen Flankenabstand 28b auf, der dem minimalen Flankenabstand 28a zuzüglich einem Bruchteil des minimalen Flankenabstands 28a entspricht. Das wiederum darunter gezeigte Codesymbol 16c weist einen Flankenabstand 28c auf, der dem minimalen Flankenabstand 28a zuzüglich einem Bruchteil des minimalen Flankenabstands 28a entspricht, wobei der Bruchteil größer als beim darüber gezeigten Codesymbol 16b ist. Das untere Codesymbol 16d weist einen Flankenabstand 28d auf, der dem minimalen Flankenabstand 28a zuzüglich einem Bruchteil des minimalen Flankenabstands 28a entspricht, wobei der Bruchteil wiederum größer als beim darüber gezeigten Codesymbol 16c ist. Alle Codesymbole 16a - 16d unterscheiden sich bezüglich ihres Flankenabstands 28 und sind somit eindeutig den Datensymbolen 16a - 16d zuzuweisen.

Die Flankenabstände 28 werden beim erfindungsgemäßen Verfahren nicht mehr von einem Takt abhängig gemacht, indem diese jeweils ein ganzzahliges Vielfaches der Periodendauer des Taktes aufweisen. Jedoch wird auch erfindungsgemäß ein minimaler Flankenabstand 28a definiert. Dieser legt einen zeitlichen Abstand der Signalflanken 28a, 28b der Codesymbole 16 fest, sodass aus den Codesymbolen 16 erzeugte Signalflanken 28c, 28d des Sendesignals 12 bzw. des Empfangssignals 13 immer ein vorbestimmtes minimales Potential 23 oder ein maximales Potential 24 auf dem realen Kanal erreichen, bevor eine nächste Signalflanke 28c, 28d in Abhängigkeit der Codesymbole 16 erzeugt wird. Damit einspricht der minimale Flankenabstand 28a des erfindungsgemäßen Verfahrens weiterhin der Periodendauer eines dem bekannten Verfahren zugrunde gelegten Taktes, der gewährleistet, dass eine fehlerfreie Übertragung erreicht wird.

Es ist darauf hinzuweisen, dass die Codesymbole 16 in Fig. 3 durch zwei Signalflanken 26a, 26b dargestellt sind, zwischen denen ein hohes Potentialniveau 20b liegt. Bei dem erfindungsgemäßen Verfahren enthalten Codesymbole 16 jedoch nur Informationen über Abstände der Signalflanken 26a, 26b. Ob diese durch einen Wechsel von niedrigen Potentialniveaus 20a auf hohe Potentialniveaus 20b oder umgekehrt auftreten, ist für das erfindungsgemäße Verfahren irrelevant. Das Sendesignal 12 wird nur in Abhängigkeit der Flankenabstände 28 der Codesymbole 16 erzeugt, die bezüglich ihres Potentialniveaus 20a, 20b aufeinanderfolgend alternieren.

Jedem Datensymbol 14a - 14d, bestehend aus zwei Bits, wird somit jeweils ein Codesymbol 16a - 16d des Coderaums 40 zugewiesen. Gemäß der Erfindung ist eine eindeutige Zuweisung jedes unterschiedlichen Datensymbols 14 zu genau einem Codesymbol 16 nicht vorgeschrieben. Es können auch gleiche Datensymbole 14 unterschiedlichen Codesymbolen 16 zugewiesen werden.

Fig. 4 zeigt die erfindungsgemäße Abbildung, also die Codierung, eines mit dem in Fig. 1 und 2 vergleichbaren digitalen Signals 10 auf ein Sendesignal 12. Vergleicht man die Zeitachse 17 der Fig. 1, 2 und 4 so ist in Fig. 4 zu erkennen, dass die Bitrate annähernd im Vergleich zu Fig. 2 verdoppelt wurde. Es wird wieder der gleiche reale Kanal zugrunde gelegt, der gleiche kapazitive Effekte wie in Fig. 1 und 2 aufweist, aufgrund dessen die Signalflanken 22c, 22d des Sendesignals in Fig. 4 ebenfalls die gleiche Steigung wie in Fig. 1 und 2 aufweisen. Gleiche Bezugszeichen in Fig. 4 bezeichnen gleiche Merkmale wie in Fig. 1 und 2.

Fig. 4 zeigt wiederum die Zuweisung der Codesymbole 16 zu den Datensymbolen 14, wobei die Codesymbole 16 und die Datensymbole 14 den in Fig. 3 beschriebenen Codesymbolen 16a - 16d und Datensymbolen 14a - 14d entsprechen. Dazu werden aus dem digitalen Signal 10 die Datensymbole 14a - 14d gebildet, indem jedes Datensymbol 14a - 14d jeweils aus zwei Bits 18 des digitalen Signals 10 gebildet werden. Diesen Datensymbolen 14a - 14d werden, entsprechend der in Fig. 3 dargestellten Zuweisung, die Codesymbole 16a - 16d zugewiesen. Auch in Fig. 3 wird das Sendesignal 12 in Abhängigkeit der Codesymbole 16 auf dem realen Kanal erzeugt. Dazu wird erfindungsgemäß immer abwechselnd ein niedriges Potentialniveau 20a und ein hohes Potentialniveau auf 20b dem realen Kanal erzeugt, wobei jedes Potentialniveaus 20a, 20b für die Zeitdauern auf dem realen Kanal erzeugt werden, die jeweils den Flankenabständen 28 der Codesymbole 16 entsprechen.

Im Gegensatz zu Fig. 2 wird jedoch ein minimaler Flankenabstand 28a zugrunde gelegt, der dem in Fig. 1 entspricht, wodurch das in Abhängigkeit der Codesymbole 16 erzeugte Sendesignal 12 das minimale Potentialniveau 22 und das maximale Potentialniveau 24 nach jeder Signalflanke 22 erreicht, bevor das Sendesignal 14 in Abhängigkeit vom nächsten Codesymbol 16 erzeugt wird.

Erfindungsgemäß wird mit einem vergleichbaren minimalen Flankenabstand 28a in Fig. 1 und 4 die Bitrate erhöht, indem mit einem Flankenabstand 28 jeweils ein Datensymbol 16a - 16d mit zwei Bits 18 übertragen wird, wobei alle der definierten Flankenabstände 28 der Codesymbole 16 kürzer als das doppelte ganzzahlige des minimalen Flankenabstands 28a sind. Im dargestellten Falle wird - wie zuvor - davon ausgegangen, dass das Sendesignal 12 dem Empfangssignal 13 entspricht.

Im Decodierer werden erfindungsgemäß nun auch Flankenabstände zwischen aufeinanderfolgenden Signalflanken 26c, 26d des Sendesignals 12 bzw. des Empfangssignals 13 betrachtet, um die Codesymbole 16 zu erfassen. In Fig. 4 wird dazu ein Potential 34 vorbestimmt. Es können auch unterschiedliche Potentiale für z.B. eine steigende und eine fallende Signalflanke 26c, 26d des Sendesignals 12 bzw. des Empfangssignals 13 vorbestimmt werden. Im dargestellten Beispiel wird jedoch ein Potential, unabhängig davon, ob die Signalflanken 26c, 26d ansteigen oder abfallen, festgelegt. D.h. im Decodierer wird der Abstand zwischen benachbarten Signalflanken 26c, 26d des Sendesignals 12 bzw. des Empfangssignals 13 zwischen Bereichen gemessen, in denen die Signalflanken 26c, 26d das vorbestimmte Potential aufweisen. Im Decodierer werden somit die Codesymbole 16 erfasst, indem die den Codesymbolen 16 entsprechenden Flankenabstände 28 des Sendesignals erfasst werden. Diesen Codesymbolen wird im Decodierer entsprechend jeweils ein Datensymbol 14 zugeordnet und diese Datensymbole 14 in Bits 18 zerteilt. Aus diesen Bits wird zuletzt wieder das digitale Signal 10 erhalten.

Eine Abbildung des Empfangssignals 13 auf das digitale Signal 10 ist also im Decodierer mit dem erfindungsgemäßen Verfahren eindeutig möglich, wobei die Bitrate im Vergleich zum Non-Return-To-Zero-Verfahren erhöht wird.

Fig. 5 zeigt den erfindungsgemäßen Codierer 36, dem an seinem Eingang 38 das digitale Signal 10 zugeführt wird. Der Codierer 36 fasst Bits 18 des digitalen Signals in Datensymbole 14 zusammen und weist diesen Codesymbole 16 eines Coderaums 40 zu. Am Ausgang des Codierers 41 wird das Sendesignals 12 in Abhängigkeit der Codesymbole 16 erzeugt.

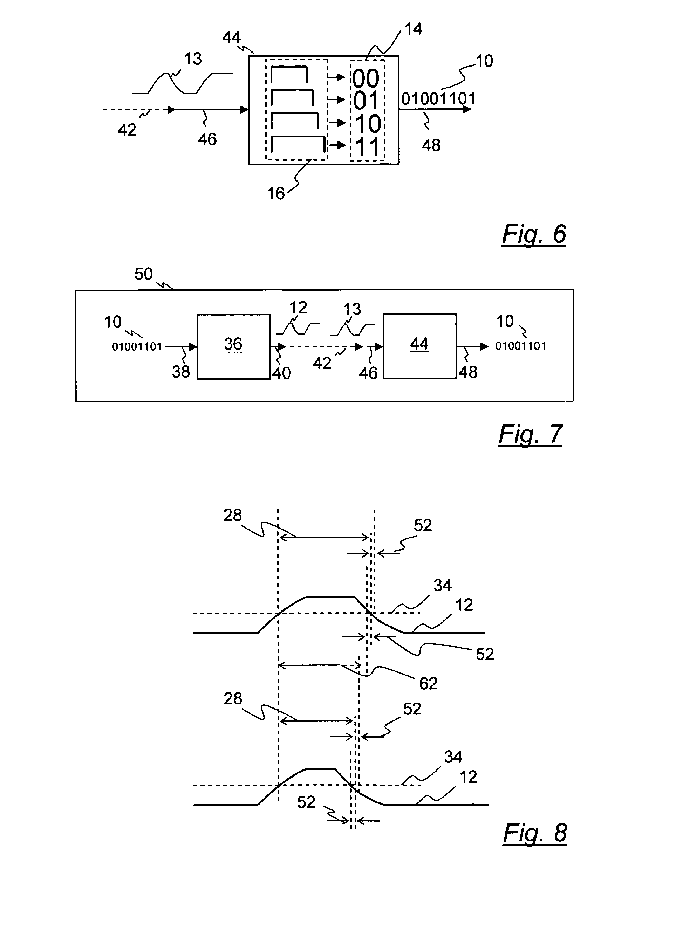

Fig. 6 zeigt den erfindungsgemäßen Decodierer 44, dem an seinem Eingang 46 das Empfangssignal 13 zugeführt wird. Der Decodierer 44 erfasst die Codesymbole 16 des Empfangssignal 13, indem die Flankenabstände 28 des Empfangssignals 13 in einem oder mehreren definierten Potentialen 34 aufeinanderfolgender Signalflanken 26c, 26d des Empfangssignal 13 gemessen werden. Die erfassten Codesymbole 16 des Coderaums 40 werden daraufhin Datensymbolen 14 zugewiesen, die zwei oder mehr als zwei Bits 18 enthalten. Ferner werden die Datensymbole 14 in Bits 18 zerteilt und aus den einzelnen Bits 18 das digitale Signal 10 erhalten, das am Ausgang 48 des Decodierers 44 ausgegeben wird.

Fig. 7 zeigt ein System 50 aus einem Codierer 36 und einem Decodierer 41, wobei der Codierer 36 und der Decodierer 44 durch einen realen Kanal 42 zwischen dem Ausgang 41 des Codierers 36 und dem Eingang 46 des Decodierers 44 verbunden sind. Dem Eingang 38 des Decodierers 36 wird das digitale Signal 10 zugeführt und in das Sendesignal 12 abgebildet, das am Ausgang 41 ausgegeben wird. Dem Decodierer 44 wird das dem Sendesignal entsprechende Empfangssignal 13 am Eingang 46 zugeführt, wobei der Decodierer 44 dieses zurück in das digitale Signal 12 abbildet.

Fig. 8 zeigt zwei auf dem realen Kanal 42 in Abhängigkeit der erfindungsgemäßen Codesymbole erzeugte Flankenabstände 28 des Sendesignals 12. Die Flankenabstände 28 können als "benachbart" bezeichnet werden. Diese "benachbarten" Signalflanken entsprechen z. B. den oberen beiden Codesymbolen 16a, 16d der Fig. 3, die sich also bezüglich ihrer Flankenabstände 28 weniger untereinander unterscheiden als die anderen Codesymbole 16 eines Coderaums 40.

Zur Unterscheidung dieser beiden Codesymbole 16 werden im Decodierer 44 zwei unterschiedliche Flankenabstände 28 definiert. Zudem wird ein Toleranzbereich 52 definiert, der dazu führt, dass jedes der Codesymbole 16 eindeutig im Decodierer erfasst wird, auch wenn der jeweils erfasste Flankenabstand 28 um den Toleranzwert 52 nach oben oder unten vom definierten Flankenabstand abweicht.

Ferner wird ein Toleranzwert 52 aber nur so ausgelegt, dass Flankenabstände 28 in einem zeitlichen Bereich 62 definiert sind, die keinem Codesymbol zugeordnet werden. Flankenabstände 28, die kleiner als der obere dargestellte Flankenabstand 28 abzüglich dem Toleranzwert 52 und größer als der untere dargestellte Flankenabstand 28 zuzüglich dem Toleranzwert 52 sind, befinden sich in einem zeitlichen Bereich 62 und werden nicht eindeutig einem Codesymbol zugeordnet. Diese Flankenabstände 28 führen dazu, dass ein Codesymbol 16 als Übertragungsfehler erkannt wird.

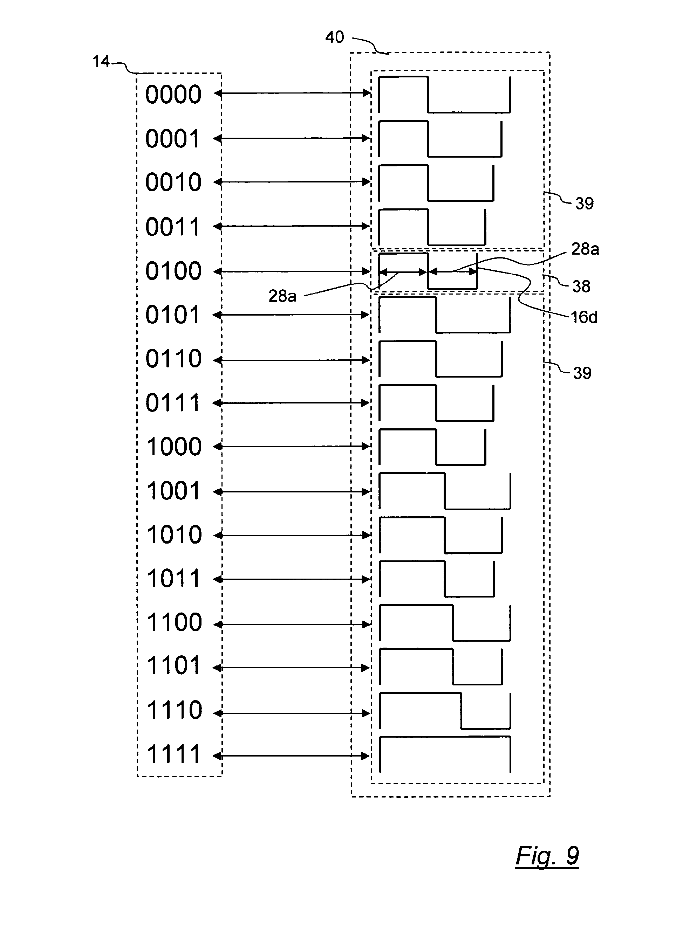

Fig. 9 zeigt alternativ gebildete Datensymbolen 14 und Codesymbolen 16 eines Coderaums 40 und deren Zuweisung zueinander. Bei dieser Ausführungsform des erfindungsgemäßen Verfahrens sind unterschiedliche Datensymbole 14 aus den Kombinationen von jeweils vier Bits 18 möglich. Hierzu ist entsprechend ein Coderaum 40 mit sechzehn Codesymbolen 16 dargestellt. Bei dieser Ausführungsform weisen alle bis auf das untere Codesymbol 16 zwei Flankenabstände 28 auf. Das untere Codesymbol 16 weist hingegen nur einen Flankenabstand 28 auf. Die Codesymbole 16 sind alle bis auf das Codesymbol 16e der zweiten Gruppe 39 von Codesymbolen 16 zuzuordnen. Das Codesymbol 16e ist der ersten Gruppe 38 von Codesymbolen 16 zuzuordnen, da dies ausschließlich Flankenabstände mit dem minimalen Flankenabstand 28a umfasst.

Wie in Fig. 4 ist auch hier darauf hinzuweisen, dass die Codesymbole 16 durch Signalflanken 26a, 26b dargestellt sind, zwischen denen hohe Potentialniveaus 20b oder niedrige Potentialniveaus 20a dargestellt sind. Da es bei dem erfindungsgemäßen Verfahren jedoch ausschließlich auf die Flankenabstände ankommt, könnten die Potentialniveaus 20a, 20b der Flankenabstände 28 der Codesymbole 16 auch mit dem entsprechend anderen Potentialniveau 20a, 20b dargestellt sein.

Das erfindungsgemäße Codier- bzw. Decodierverfahren kann vorteilhafterweise auch im Bereich der Wasserschallortung eingesetzt werden. Hierbei werden die elektrischen Signale einer Vielzahl von Wandlern zunächst durch die den jeweiligen Wandlern jeweils zugeordnete Signalverarbeitungseinheit vorverarbeitet und in digitale Signale 10 gewandelt. Ein in der jeweiligen Signalverarbeitungseinheit vorgesehener Codierer 36 bildet das digitale Signal 10 in ein Sendesignal 12 ab. Das Sendesignal 12 wird auf einem realen Kanal 42, z.B. einer elektrischen Leitung, zu einer zentralen Signalverarbeitungseinrichtung im Bootskörper übertragen. Ein in der zentralen Signalverarbeitungseinheit vorgesehener Decodierer 44 bildet das als Sendesignal 12 gesendete und als Empfangssignal 13 empfangene Signal wieder in ein digitales Signal 10 ab.

Alle in der vorgenannten Figurenbeschreiben, in den Ansprüchen und in der Beschreibungseinleitung genannten Merkmalen sind sowohl einzeln als auch in beliebiger Kombination miteinander einsetzbar. Die Offenbarung der Erfindung ist somit nicht auf die beschriebenen bzw. beanspruchten Merkmalskombinationen beschränkt. Vielmehr sind alle Merkmalskombinationen als offenbart zu betrachten.

## Patentansprüche

1. Codierer zur Abbildung eines digitalen Signals (10) in ein Sendesignal (12) zur Übertragung auf einem realen Kanal (42), wobei der Codierer (36) derart ausgebildet ist, um Datensymbolen (14) des digitalen Signals (10) Codesymbole (16) eines Coderaumes (40) zuzuweisen und das Sendesignal (12) in Abhängigkeit der Codesymbole (16) zu erzeugen, wobei das Sendesignal (12) Signalflanken (26c, 26d) aufweist, die aus dem Übergang eines Potentialniveaus (20a, 20b) zu einem anderen Potentialniveau (20a, 20b) bestehen, und Flankenabstände (28) durch den zeitlichen Abstand zwischen mindestens zwei gleichen oder vorbestimmten unterschiedlichen Potentialen (34) benachbarter Signalflanken (26c, 26d) definiert sind, **dadurch gekennzeichnet, dass**
die Datensymbole (14) jeweils zwei oder mehr als zwei Bits (18) des digitalen Signals (12) aufweisen und der Coderaum (40) Codesymbole (16) zweier Gruppen umfasst, wobei jedes Codesymbol (16) einen oder eine Mehrzahl von Flankenabständen (28) aufweist, wobei
a) in der ersten Gruppe (38) der Flankenabstand (28) bzw. jeder der Flankenabstände (28) dem minimalen Flankenabstand (28a) oder einem ganzzahligen Vielfachen des minimalen Flankenabstands (28a) entspricht und
b) in der zweiten Gruppe (39) der Flankenabstand (28) bzw. einer, mehrere oder alle der Mehrzahl von Flankenabständen (28) einem oder mehreren ganzzahligen Vielfachen zuzüglich einem Bruchteil eines ganzzahligen Vielfachen des minimalen Flankenabstands (28a) entspricht bzw. entsprechen.

2. Codierer nach Anspruch 1,
**dadurch gekennzeichnet, dass**
der Codierer derart ausgebildet ist, um gleichen Datensymbolen (14) jeweils das gleiche Codesymbol (16) zuzuweisen.

3. Codierer nach Anspruch 1 oder 2,
**dadurch gekennzeichnet, dass**
der Codierer (36) derart ausgebildet ist, um jedes Datensymbol (14) aus der gleichen Anzahl von Bits (18) zusammenzufassen.

4. Codierer nach einem der vorherigen Ansprüche,
**dadurch gekennzeichnet, dass**
jedes der Codesymbole (16) aus der gleichen Anzahl eines oder mehrerer Flankenabstände (28) besteht.

5. Decodierer (44) zur Abbildung eines als Sendesignal (12) gesendeten und als Empfangssignal (13) empfangenen Signals in ein digitales Signal (10) zum Empfangen von einem realen Kanal (42), indem der Decodierer (44) derart ausgebildet ist, um Codesymbolen (16) eines Coderaumes (40) Datensymbole (14) des digitalen Signals (10) zuzuweisen und die Codesymbole (16) in Abhängigkeit des Empfangssignals (13) zu erfassen, wobei das Empfangssignal (13) Signalflanken (26c, 26d) aufweist, die aus dem Übergang eines Potentialniveaus (20a, 20b) zu einem anderen Potentialniveau (20a, 20b) bestehen und Flankenabstände (28) durch den zeitliche Abstand zwischen mindestens zwei gleichen oder vorbestimmten unterschiedlichen Potentialen (34) benachbarter Signalflanken definiert sind,
**dadurch gekennzeichnet, dass**
die Datensymbole (14) jeweils zwei oder mehr als zwei Bits (18) des digitalen Signals (12) aufweisen und der Coderaum (40) Codesymbole (16) zweier Gruppen umfasst, wobei jedes Codesymbol (16) einen oder eine Mehrzahl von Flankenabständen (28) aufweist, wobei
a) in der ersten Gruppe (38) der Flankenabstand (28) bzw. jeder der Flankenabstände (28) dem minimalen Flankenabstand (28a) oder einem ganzzahligen Vielfachen des minimalen Flankenabstands (28a) entspricht und
b) in der zweiten Gruppe (39) der Flankenabstand (28) bzw. einer, mehrere oder alle der Mehrzahl von Flankenabständen (28) einem oder mehreren ganzzahligen Vielfachen zuzüglich einem Bruchteil eines ganzzahligen Vielfachen des minimalen Flankenabstands (28a) entspricht bzw. entsprechen.

6. Decodierer nach Anspruch 5,
**dadurch gekennzeichnet, dass**
der Decodierer (44) derart ausgebildet ist, um gleichen Codesymbolen (16) jeweils das gleiche Datensymbol (14) zuzuweisen.

7. Decodierer nach Anspruch 5 oder 6,
**dadurch gekennzeichnet, dass**
der Decodierer (44) derart ausgebildet ist, um jedes Datensymbol (14) in die gleiche Anzahl von Bits (18) aufzuteilen.

8. Decodierer nach einem der Ansprüche 5 bis 7,
**dadurch gekennzeichnet, dass**
jedes der Codesymbole (16) aus der gleichen Anzahl eines oder mehrerer Flankenabstände (28) besteht.

9. Decodierer nach einem der Ansprüche 5 bis 8,
**dadurch gekennzeichnet, dass**
jedes Codesymbole (16) einen festgelegten Flankenabstand (28) oder mehrere festgelegten Flankenabstände (28) einer festgelegten Reihenfolge aufweist und der Decodierer (44) derart ausgebildet ist, um jedes Codesymbol (16) durch einen festgelegten Flankenabstand (28) oder mehrere festgelegte Flankenabstände (28) einer festgelegten Reihenfolge und durch einen Flankenabstand (28) oder mehrere Flankenabstände (28), die um einen Toleranzwert (50) abweichen, zu erfassen.

10. Decodierer nach einem der Ansprüche 5 bis 9,
**dadurch gekennzeichnet, dass**
der Decodierer (44) derart ausgebildet ist, um die Flankenabstände (28), die nicht zur Erfassung eines Codesymbols (16) führen, als Übertragungsfehler zu erkennen.

11. Codierverfahren zum Abbilden eines digitalen Signals (10) in ein Sendesignal (12) zum Übertragen auf einem realen Kanal (42), wobei Datensymbolen (14) des digitalen Signals (10) Codesymbole (16) eines Coderaumes (40) zugewiesen werden und das Sendesignal (12) in Abhängigkeit der Codesymbole (16) erzeugt wird, wobei das Sendesignal (12) Signalflanken (22c, 22d) aufweist, die aus dem Übergang eines Potentialniveaus (20a, 20b) zu einem anderen Potentialniveau (20a, 20b) bestehen und Flankenabstände (28) durch den zeitlichen Abstand zwischen mindestens zwei gleichen oder vorbestimmten unterschiedlichen Potentialen (34) benachbarter Signalflanken (22c, 22d) definiert sind,
**dadurch gekennzeichnet, dass**
die Datensymbole (14) jeweils zwei oder mehr als zwei Bits (18) des digitalen Signals (12) aufweisen und der Coderaum (40) Codesymbole (16) zweier Gruppen umfasst, wobei jedes Codesymbol (16) einen oder eine Mehrzahl von Flankenabständen (28) aufweist, wobei
a) in der ersten Gruppe (38) der Flankenabstand (28) bzw. jeder der Flankenabstände (28) dem minimalen Flankenabstand (28a) oder einem ganzzahligen Vielfachen des minimalen Flankenabstands (28a) entspricht und
b) in der zweiten Gruppe (39) der Flankenabstand (28) bzw. einer, mehrere oder alle der Mehrzahl von Flankenabständen (28) einem oder mehreren ganzzahligen Vielfachen zuzüglich einem Bruchteil eines ganzzahligen Vielfachen des minimalen Flankenabstands (28a) entspricht bzw. entsprechen.

12. Decodierverfahren zum Abbilden eines als Sendesignal (12) gesendeten und als Empfangssignal (13) empfangenen Signals in ein digitales Signal (10) zum Empfangen von einem realen Kanal (42), wobei Codesymbolen (16) eines Coderaumes (40) Datensymbole (14) des digitalen Signals (10) zugewiesen werden und die Codesymbole (16) in Abhängigkeit des Empfangssignals (13) erfasst werden, wobei das Empfangssignal (13) Signalflanken (22c, 22d) aufweist, die aus dem Übergang eines Potentialniveaus (20a, 20b) zu einem anderen Potentialniveau (20a, 20b) bestehen und Flankenabstände (28) durch den zeitliche Abstand zwischen mindestens zwei gleichen oder vorbestimmten unterschiedlichen Potentialen (34) benachbarter Signalflanken (22c, 22d) definiert sind,
**dadurch gekennzeichnet, dass**
die Datensymbole (14) jeweils zwei oder mehr als zwei Bits (18) des digitalen Signals (12) aufweisen und der Coderaum (40) Codesymbole (16) zweier Gruppen umfasst, wobei jedes Codesymbol (16) einen oder eine Mehrzahl von Flankenabständen (28) aufweist, wobei
a) in der ersten Gruppe (38) der Flankenabstand (28) bzw. jeder der Flankenabstände (28) dem minimalen Flankenabstand (28a) oder einem ganzzahligen Vielfachen des minimalen Flankenabstands (28a) entspricht und
b) in der zweiten Gruppe (39) der Flankenabstand (28) bzw. einer, mehrere oder alle der Mehrzahl von Flankenabständen (28) einem oder mehreren ganzzahligen Vielfachen zuzüglich einem Bruchteil eines ganzzahligen Vielfachen des minimalen Flankenabstands (28a) entspricht bzw. entsprechen.

13. System aus einem Codierer (36) nach einem der Ansprüche 1 bis 4 zur Durchführung eines Codierverfahrens nach Anspruch 11 und einem Decodierer (44) nach einem der Ansprüche 5 bis 10 zur Durchführung eines Decodierverfahrens nach Anspruch 12.

## Geänderte Patentansprüche

### Geänderte Patentansprüche gemäss Regel 137(2) EPÜ.

**1.** Codierer zur Abbildung eines digitalen Signals (10) in ein Sendesignal (12) zur Übertragung auf einem realen Kanal (42), wobei der Codierer (36) derart ausgebildet ist, um Datensymbolen (14) des digitalen Signals (10) Codesymbole (16) eines Coderaumes (40) zuzuweisen, indem den Datensymbolen (14) jeweils ein Codesymbol (16) zugeordnet wird, und das Sendesignal (12) in Abhängigkeit der Codesymbole (16) zu erzeugen, wobei das Sendesignal (12) Signalflanken (26c, 26d) aufweist, die aus dem Übergang eines Potentialniveaus (20a, 20b) zu einem anderen Potentialniveau (20a, 20b) bestehen, und Flankenabstände (28) durch den zeitlichen Abstand zwischen mindestens zwei gleichen oder vorbestimmten unterschiedlichen Potentialen (34) benachbarter Signalflanken (26c, 26d) definiert sind,
**dadurch gekennzeichnet, dass**
die Datensymbole (14) jeweils zwei oder mehr als zwei Bits (18) des digitalen Signals (12) aufweisen und der Coderaum (40) Codesymbole (16) zweier Gruppen umfasst, wobei jedes Codesymbol (16) einen oder eine Mehrzahl von Flankenabständen (28) aufweist, wobei
a) in der ersten Gruppe (38) der Flankenabstand (28) bzw. jeder der Flankenabstände (28) dem minimalen Flankenabstand (28a) entspricht und
b) in der zweiten Gruppe (39) der Flankenabstand (28) bzw. einer, mehrere oder alle der Mehrzahl von Flankenabständen (28) einem oder mehreren ganzzahligen Vielfachen zuzüglich einem Bruchteil eines ganzzahligen Vielfachen des minimalen Flankenabstands (28a) entspricht bzw. entsprechen.

**5.** Decodierer (44) zur Abbildung eines als Sendesignal (12) gesendeten und als Empfangssignal (13) empfangenen Signals in ein digitales Signal (10) zum Empfangen von einem realen Kanal (42), indem der Decodierer (44) derart ausgebildet ist, um Codesymbolen (16) eines Coderaumes (40) Datensymbole (14) des digitalen Signals (10) zuzuweisen, indem den Codesymbolen (16) jeweils ein Datensymbol (14) zugeordnet wird und die Codesymbole (16) in Abhängigkeit des Empfangssignals (13) zu erfassen, wobei das Empfangssignal (13) Signalflanken (26c, 26d) aufweist, die aus dem Übergang eines Potentialniveaus (20a, 20b) zu einem anderen Potentialniveau (20a, 20b) bestehen und Flankenabstände (28) durch den zeitliche Abstand zwischen mindestens zwei gleichen oder vorbestimmten unterschiedlichen Potentialen (34) benachbarter Signalflanken definiert sind,
**dadurch gekennzeichnet, dass**
die Datensymbole (14) jeweils zwei oder mehr als zwei Bits (18) des digitalen Signals (12) aufweisen und der Coderaum (40) Codesymbole (16) zweier Gruppen umfasst, wobei jedes Codesymbol (16) einen oder eine Mehrzahl von Flankenabständen (28) aufweist, wobei
a) in der ersten Gruppe (38) der Flankenabstand (28) bzw. jeder der Flankenabstände (28) dem minimalen Flankenabstand (28a) entspricht und
b) in der zweiten Gruppe (39) der Flankenabstand (28) bzw. einer, mehrere oder alle der Mehrzahl von Flankenabständen (28) einem oder mehreren ganzzahligen Vielfachen zuzüglich einem Bruchteil eines ganzzahligen Vielfachen des minimalen Flankenabstands (28a) entspricht bzw. entsprechen.
[Es folgen die ursprünglichen Ansprüche 6 bis 10]

**11.** Codierverfahren zum Abbilden eines digitalen Signals (10) in ein Sendesignal (12) zum Übertragen auf einem realen Kanal (42), wobei Datensymbolen (14) des digitalen Signals (10) Codesymbole (16) eines Coderaumes (40) zugewiesen werden, indem den Datensymbolen (14) jeweils ein Codesymbol (16) zugeordnet wird, und das Sendesignal (12) in Abhängigkeit der Codesymbole (16) erzeugt wird, wobei das Sendesignal (12) Signalflanken (22c, 22d) aufweist, die aus dem Übergang eines Potentialniveaus (20a, 20b) zu einem anderen Potentialniveau (20a, 20b) bestehen und Flankenabstände (28) durch den zeitlichen Abstand zwischen mindestens zwei gleichen oder vorbestimmten unterschiedlichen Potentialen (34) benachbarter Signalflanken (22c, 22d) definiert sind,
**dadurch gekennzeichnet, dass**
die Datensymbole (14) jeweils zwei oder mehr als zwei Bits (18) des digitalen Signals (12) aufweisen und der Coderaum (40) Codesymbole (16) zweier Gruppen umfasst, wobei jedes Codesymbol (16) einen oder eine Mehrzahl von Flankenabständen (28) aufweist, wobei
a) in der ersten Gruppe (38) der Flankenabstand (28) bzw. jeder der Flankenabstände (28) dem minimalen Flankenabstand (28a) entspricht und
b) in der zweiten Gruppe (39) der Flankenabstand (28) bzw. einer, mehrere oder alle der Mehrzahl von Flankenabständen (28) einem oder mehreren ganzzahligen Vielfachen zuzüglich einem Bruchteil eines ganzzahligen Vielfachen des minimalen Flankenabstands (28a) entspricht bzw. entsprechen.

**12.** Decodierverfahren zum Abbilden eines als Sendesignal (12) gesendeten und als Empfangssignal (13) empfangenen Signals in ein digitales Signal (10) zum Empfangen von einem realen Kanal (42), wobei Codesymbolen (16) eines Coderaumes (40) Datensymbole (14) des digitalen Signals (10) zugewiesen werden, indem den Codesymbolen (16) jeweils ein Datensymbol (14) zugeordnet wird, und die Codesymbole (16) in Abhängigkeit des Empfangssignals (13) erfasst werden, wobei das Empfangssignal (13) Signalflanken (22c, 22d) aufweist, die aus dem Übergang eines Potentialniveaus (20a, 20b) zu einem anderen Potentialniveau (20a, 20b) bestehen und Flankenabstände (28) durch den zeitliche Abstand zwischen mindestens zwei gleichen oder vorbestimmten unterschiedlichen Potentialen (34) benachbarter Signalflanken (22c, 22d) definiert sind, **dadurch gekennzeichnet, dass**
die Datensymbole (14) jeweils zwei oder mehr als zwei Bits (18) des digitalen Signals (12) aufweisen und der Coderaum (40) Codesymbole (16) zweier Gruppen umfasst, wobei jedes Codesymbol (16) einen oder eine Mehrzahl von Flankenabständen (28) aufweist, wobei
a) in der ersten Gruppe (38) der Flankenabstand (28) bzw. jeder der Flankenabstände (28) dem minimalen Flankenabstand (28a) entspricht und
b) in der zweiten Gruppe (39) der Flankenabstand (28) bzw. einer, mehrere oder alle der Mehrzahl von Flankenabständen (28) einem oder mehreren ganzzahligen Vielfachen zuzüglich einem Bruchteil eines ganzzahligen Vielfachen des minimalen Flankenabstands (28a) entspricht bzw. entsprechen.
